# EUROPEAN PATENT APPLICATION

(11) **EP 4 310 065 A1**
(43) Date of publication of application: **24.01.2024**
(21) Application number: 22774941.3
(22) Date of filing: 01.03.2022
(51) Int. Cl.: C04B 37/02, H05K 1/03, H05K 3/38

(54) **COMPOSITE SUBSTRATE**

(30) Priority: 24.03.2021 JP 2021049936
(71) Applicant: Denka Company Limited, Tokyo 103-8338 (JP)
(72) Inventor: AONO Ryota, Tokyo 103-8338 (JP); TAKEFUJI Takayuki, Tokyo 103-8338 (JP); USHIJIMA Yutaka, Tokyo 103-8338 (JP); TANAKA Junichi, Tokyo 103-8338 (JP)
(74) Representative: Gulde & Partner
(86) International application number: PCT/JP2022/008564
(87) International publication number: WO 2022/202144

(57) **Abstract**

According to an aspect of the present disclosure, there is provided a composite substrate including a ceramic plate and a metal base material joined onto the ceramic plate via a brazing material layer containing silver and an active metal, in which X is 70 to 110 HV and a ratio of Y to X is 0.92 or less, where a Vickers hardness at a position of 20 µm from the ceramic plate toward the metal base material is X and a Vickers hardness at a position of 70 µm from the ceramic plate toward the metal base material is Y.

## Description

### Technical Field

The present disclosure relates to a composite substrate.

### Background Art

As the performance of industrial equipment such as robots and motors has improved, the amount of heat generated from semiconductor devices mounted on power modules has been increasing. In order to efficiently dissipate this heat, a circuit substrate including a ceramic plate having good heat conduction is used. Thermal stress is generated in such a circuit substrate due to heating and cooling steps when joining a ceramic plate and a metal plate via a brazing material and heat cycles during use. This thermal stress may cause cracks in the ceramic substrate or peeling off of the metal plate.

On the other hand, Patent Literature 1 describes a ceramic circuit substrate in which heat cycle characteristics are improved by making the coefficient of thermal expansion of a brazing material close to that of the ceramic substrate.

### Citation List

### Patent Literature

[Patent Literature 1] Japanese Unexamined Patent Publication No. 2014-118310

### Summary of Invention

### Technical Problem

A circuit substrate is required to have sufficiently high reliability depending on the application in which the circuit substrate is used. For example, in the field of electric train drive units and power modules in electric vehicles or the like, it is desirable to be able to relieve thermal stresses such that the properties can be maintained even after undergoing heat cycles under harsh operating conditions while ceramic plates and metal plates are joined with sufficient joining strength. In order to exhibit sufficient joining strength, it is conceivable to strengthen the joining with the ceramic plate by performing joining at a high temperature. However, according to the study of the present inventors, joining at a high temperature increases the hardness in the vicinity of the brazing material layer, which tends to make it difficult to relieve the thermal stress generated during the heat cycle. It is useful when there is a composite substrate that can achieve both joining strength and heat cycle characteristics.

An object of the present disclosure is to provide a composite substrate having excellent heat cycle characteristics and joining strength between a ceramic plate and a metal base material.

### Solution to Problem

According to an aspect of the present disclosure, there is provided a composite substrate including a ceramic plate and a metal base material joined onto the ceramic plate via a brazing material layer containing silver and an active metal, in which X is 70 to 110 HV and a ratio of Y to X is 0.92 or less, where a Vickers hardness at a position of 20 µm from the ceramic plate toward the metal base material is X and a Vickers hardness at a position of 70 µm from the ceramic plate toward the metal base material is Y

The composite substrate has a Vickers hardness such that X is within a predetermined range, and thus the joining is sufficiently fixed in the range of 20 µm or less from the ceramic plate toward the metal base material, and excellent joining strength between the ceramic plate and the metal base material can be exhibited. Further, the fact that the ratio of Y to X (the value of Y/X) is within the above range means that the Vickers hardness is excellent in the vicinity of the interface between the ceramic plate and the brazing material layer, and further, a large increase in Vickers hardness in the metal base material is suppressed by the wide diffusion of the brazing material component into the metal base material, and the thermal stress caused by the heat cycle can be relieved. Therefore, in the composite substrate, the peeling off of the metal base material from the ceramic plate due to the heat cycle is sufficiently suppressed. That is, the composite substrate can have excellent heat cycle characteristics and joining strength between the ceramic plate and the metal base material.

In the composite substrate, the ratio of Yto X may be 0.50 or more. When the ratio of Y to X is within the above range, the joining strength between the ceramic plate and the metal base material can be further improved, and both the joining strength and heat cycle characteristics can be achieved at a higher level.

The active metal may contain at least one selected from a group consisting of titanium, zirconium, hafnium, vanadium, niobium, and tantalum. As the brazing material layer contains the active metal, the adhesiveness between the ceramic plate and the metal base material can be further improved.

The ceramic plate may contain silicon nitride.

A thickness of the brazing material layer may be 20 µm or less.

### Advantageous Effects of Invention

According to the present disclosure, a composite substrate having excellent heat cycle characteristics and joining strength between a ceramic plate and a metal base material can be provided.

### Brief Description of Drawings

FIG. 1 is a schematic diagram showing an example of a composite substrate.
FIG. 2 is an enlarged sectional view of the vicinity of a joining surface of the composite substrate.

### Description of Embodiments

Hereinafter, embodiments of the present disclosure will be described with reference to the drawings as the case may be. However, the following embodiments are examples for explaining the present disclosure, and are not intended to limit the present disclosure to the following contents. In the description, the same reference numerals are used for the same elements or elements having the same functions, and duplicate descriptions are omitted depending on the case. In addition, unless otherwise specified, positional relationships such as up, down, left, and right are based on the positional relationships shown in the drawings. Furthermore, the dimensional ratios of each element are not limited to the illustrated ratios.

The materials exemplified in this specification can be used alone or in combination of two or more unless otherwise specified. The content of each component in the composition means the total amount of the plurality of substances present in the composition unless otherwise specified when there are the plurality of substances corresponding to each component in the composition.

One embodiment of the composite substrate includes a ceramic plate and a metal base material joined onto the ceramic plate via a brazing material layer containing an active metal. The joining may be performed by an active metal method. A composite substrate may have one or more metal base materials.

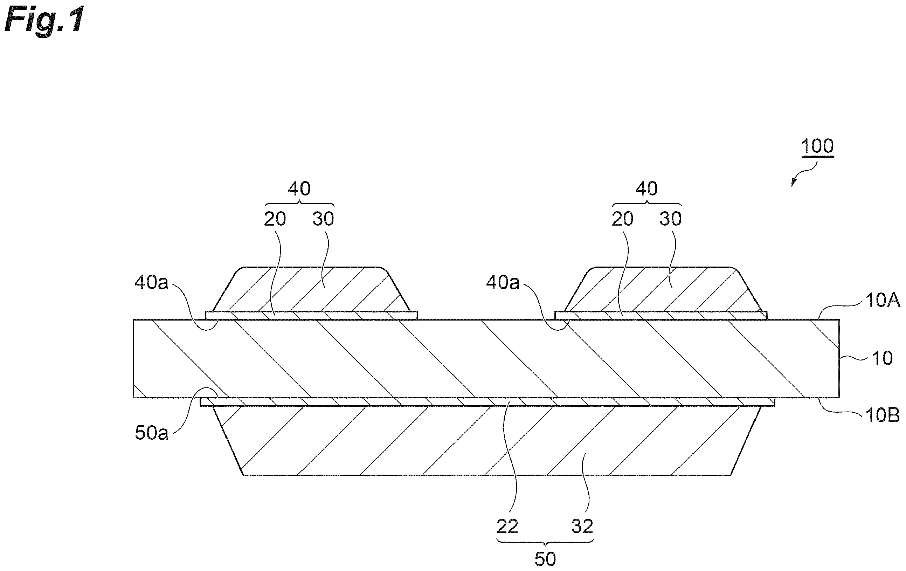

FIG. 1 is a schematic sectional view showing an example of a composite substrate, and shows a cross section of the composite substrate orthogonal to a joining surface which will be described later. A composite substrate 100 includes a ceramic plate 10, a circuit board 40 and a heat sink 50. The circuit board 40 is configured to be joined to a front surface 10A of the ceramic plate 10 at a joining surface 40a, and a metal base material 30 is configured to be joined to the ceramic plate 10 via a brazing material layer 20. The heat sink 50 is configured to be joined to a back surface 10B of the ceramic plate 10 at a joining surface 50a, and a metal base material 32 is configured to be joined to the ceramic plate 10 via a brazing material layer 22. In FIG. 1, two circuit boards 40 are joined to the front surface 10A of the ceramic plate 10, and the heat sink 50 is joined to the back surface 10B of the ceramic plate 10. However, the number of circuit boards 40 and the number of heat sinks 50 may be changed as appropriate depending on the case.

The circuit board 40 may have a function of transmitting electrical signals, while the heat sink 50 may have a function of transmitting heat. Note that the heat sink 50 may further have a function of transmitting electrical signals.

The circuit board 40 and the heat sink 50 may be made of the same material, or may be made of different materials. From the viewpoint of improving conductivity and heat dissipation, the metal base materials 30 and 32 may contain copper as a main component, for example. In this case, the circuit board 40 and the heat sink 50 may be composed of a brazing material layer and a copper plate.

In the composite substrate 100, X is 70 to 110 HV, where the Vickers hardness at a position of 20 µm from the ceramic plate 10 toward the metal base material 30 is X, and the Vickers hardness at a position of 70 µm from the ceramic plate 10 toward the metal base material 30 is Y The above X may be, for example, 72 to 97 HV, or 73 to 95 HV When X is within the above range, the joining strength between the ceramic plate 10 and the metal base material 30 can be further improved.

The ratio of Y to X (the value of Y/X) is 0.92 or less. The upper limit value of the ratio may be, for example, 0.90 or less, or 0.88 or less. When the upper limit value of the above ratio is within the above range, the heat cycle characteristics of the composite substrate 100 can be further improved. The lower limit value of the above ratio may be, for example, 0.50 or more, 0.52 or more, or 0.53 or more. When the lower limit value of the above ratio is within the above range, the active metal can be appropriately diffused into the metal base material at the interface between the brazing material layer and the metal base material, and the joining strength can be further improved. The ratio may be adjusted within the ranges mentioned above, and may be, for example, 0.50 to 0.92, or 0.53 to 0.90.

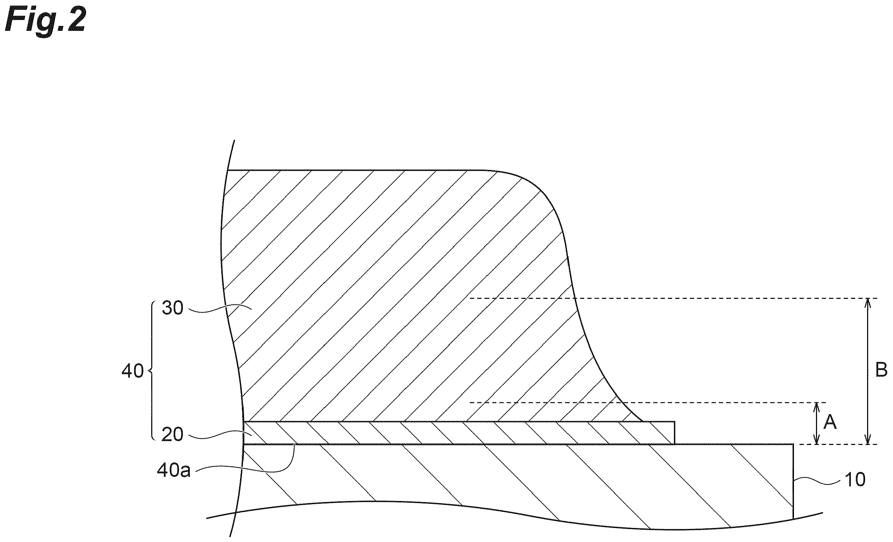

As used in this specification, Vickers hardness means a value measured according to the method described in JIS Z 2244:2009 "Vickers hardness test-Test method". Description will be made with reference to FIG. 2. FIG. 2 is an enlarged sectional view of the vicinity of the joining surface of the composite substrate, and shows a cross section orthogonal to the joining surface between the ceramic plate and the metal base material. Using the joining surface between the ceramic plate 10 and the metal base material 30 as a reference position, the position is determined by performing measurement from the reference position in the direction perpendicular to the joining surface and in the direction of the brazing material layer 20 and the metal base material 30. Vickers hardness is measured at a point separated by a distance A (for example, 20 µm) and a point separated by a distance B (for example, 70 µm) in FIG. 2. In FIG. 2, an enlarged view of the joining surface 40a on the front surface 10A of the ceramic plate 10 is shown for explanation, but also on the joining surface 50a on the back surface 10B of the ceramic plate 10, the measurement is performed in a similar manner. Regarding the Vickers hardness, in a cross-sectional surface of the composite substrate 100 including the part where the ceramic plate and the metal base material are joined via the brazing material, on each of the joining surfaces (in the case of the composite substrate 100 in FIG. 1, three places in total including on two joining surfaces 40a on the front surface 10A of the ceramic plate 10 and the joining surface 50a on the back surface 10B of the ceramic plate 10), the value of Y/X is measured at any 10 points, and the arithmetic mean value is adopted.

The ceramic plate 10 may be composed of either silicon nitride or aluminum nitride, and preferably includes silicon nitride. The ceramic plate may be, for example, an aluminum nitride sintered body or a silicon nitride sintered body.

The brazing material layers 20 and 22 are layers obtained by heat-treating a brazing material. The brazing material contains silver as a main component and active metals as subcomponents. The content of silver may be, for example, 85% by mass or more, 87% by mass or more, or 90% by mass or more based on the total amount of the brazing material layer. The content of silver may be, for example, 98% by mass or less, or 99% by mass or less based on the total amount of the brazing material layer. The active metal may contain, for example, at least one selected from the group consisting of titanium, zirconium, hafnium, vanadium, niobium, and tantalum, and may contain silver as a main component. The brazing material layers 20 and 22 may contain, for example, carbon in addition to the active metal. In addition, the brazing material layer 20 may contain metals such as copper (Cu), tin (Sn), and indium (In) for the purpose of lowering the melting point. The content of the active metal in the brazing material layer may be adjusted based on the silver content being 100 parts by mass.

When the brazing material layers 20 and 22 contain copper, it is possible to reduce the influence of the heat treatment on the constituent members in the vicinity of the joining surface, and accordingly, the reliability of the obtained composite substrate can be further improved. The content of copper in the brazing material layers 20 and 22 may be, for example, 17 parts by mass or less, 15 parts by mass or less, 14 parts by mass or less, 13 parts by mass or less, or 12 parts by mass or less with respect to 100 parts by mass of the content of silver. The content of copper in the brazing material layers 20 and 22 may be, for example, 2 parts by mass or more, 4 parts by mass or more, 6 parts by mass or more, 8 parts by mass or more, or 10 parts by mass or more with respect to 100 parts by mass of the content of silver. The content of copper in the brazing material layers 20 and 22 may be adjusted within the range described above, and may be, for example, 2 to 17 parts by mass with respect to 100 parts by mass of the content of silver.

When the brazing material layers 20 and 22 contain tin, it is possible to reduce the influence of the heat treatment on the constituent members in the vicinity of the joining surface, and accordingly, the reliability of the obtained composite substrate can be further improved. The content of tin in the brazing material layers 20 and 22 is, for example, 6.0 parts by mass or less, 5.5 parts by mass or less, 5.0 parts by mass or less, 3.0 parts by mass or less, or 1.0 part by mass or less with respect to 100 parts by mass of the content of silver. The content of tin in the brazing material layers 20 and 22 may be, for example, 0.5 parts by mass or more, 0.8 parts by mass or more, or 0.9 parts by mass or more with respect to 100 parts by mass of the content of silver. The content of tin in the brazing material layers 20 and 22 may be adjusted within the range described above, and may be, for example, 0.5 to 6.0 parts by mass with respect to 100 parts by mass of the content of silver.

When the brazing material layers 20 and 22 contain titanium, the joining strength between the ceramic plate and the metal base material can be further improved. The upper limit value of the content of titanium in the brazing material layers 20 and 22 may be, for example, 7.0 parts by mass or less, 6.0 parts by mass or less, 5.0 parts by mass or less, or 4.0 parts by mass or less with respect to 100 parts by mass of the content of silver. The lower limit value of the content of titanium in the brazing material layers 20 and 22 is, for example, 0.6 parts by mass or more, 0.8 parts by mass or more, or 1.0 part by mass or more with respect to 100 parts by mass of the content of silver. The content of titanium in the brazing material layers 20 and 22 may be adjusted within the range described above, and may be, for example, 1.0 to 5.0 parts by mass with respect to 100 parts by mass of the content of silver.

The brazing material layers 20 and 22 may contain components other than metals, such as silver and active metals, as long as the effects of the present invention are not impaired. Impurities are also included in other components. The content of other components may be, for example, 15.0% by mass or less, 14.0% by mass or less, 12.0% by mass or less, 10.0% by mass or less, 5.0% by mass or less, 3.0% by mass or less, 1.0% by mass or less, or 0.5% by mass or less based on the total amount of the brazing material layer.

The upper limit value of the thickness of the brazing material layers 20 and 22 may be, for example, 20 µm or less, 18 µm or less, or 15 µm or less. When the upper limit value of the thickness is within the above range, the heat cycle characteristics can be made more sufficient, and even after use in a high heat dissipation environment, the occurrence of peeling or the like of the brazing material layers 20 and 22 caused by thermal stress can be more sufficiently suppressed. The lower limit value of the thickness of the brazing material layers 20 and 22 may be, for example, 3 µm or more, 5 µm or more, or 8 µm or more. When the lower limit value of the thickness is within the above range, the joining strength between the ceramic plate 10 and the metal base materials 30 and 32 can be made more sufficient, and the occurrence of peeling or the like can be suppressed. The thickness of the brazing material layer may be adjusted within the above range, and may be, for example, 3 to 20 µm. The thickness of the brazing material layer in this specification means a value measured in an electron microscope image of a cross section orthogonal to the joining surface between the ceramic plate and the metal base material in the composite substrate. Regarding the thickness of the brazing material layer, in a cross-sectional surface of the composite substrate 100 including the part where the ceramic plate and the metal base material are joined via the brazing material, on each of the joining surfaces (in the case of the composite substrate 100 in FIG. 1, three places in total including two joining surfaces 40a on the front surface 10A of the ceramic plate 10 and the joining surface 50a on the back surface 10B of the ceramic plate 10), the maximum thickness of the brazing material layer is measured, and the arithmetic mean value is adopted.

The composite substrate 100 has excellent joining strength between the ceramic plate 10 and the metal base materials 30 and 32. The joining strength between the ceramic plate 10 and the metal base materials 30 and 32 can be, for example, 80 N/cm or more, 100 N/cm or more, 120 N/cm or more, or 140 N/cm or more. The joining strength means the value obtained by dividing the maximum peeling load (unit: N) when part of the metal base material is peeled off at 90° (perpendicular direction) by the width of the metal base material (unit: cm). Specifically, the measurement is performed by the method described in Examples below.

The composite substrate 100 can exhibit excellent heat cycle characteristics. Heat cycle characteristics can be evaluated by performing the temperature change test according to the method described in JIS C 60068-2-14:2011 "Environmental testing -Part 2-14: Tests-Test N: Change of temperature".

The composite substrate 100 described above can be manufactured, for example, by the following method. One embodiment of the method for manufacturing a composite substrate includes a step of forming a slurry containing an inorganic compound powder, a sintering aid, a binder resin, and a solvent to obtain a green sheet (green sheet preparation step); a step of heat-treating the green sheet to obtain a ceramic plate (ceramic plate preparation step); a step of pasting a metal base material onto a ceramic plate via a brazing material containing silver and active metal to obtain a laminate (lamination step); and a step of heat-treating the laminate to obtain a composite substrate (heat treatment step).

In the green sheet preparation step, a slurry containing components that serve as raw materials for the ceramic plate is prepared and formed into a sheet to prepare a green sheet. The slurry forming method may be, for example, a doctor blade method, an extrusion forming method, or the like.

Examples of inorganic compounds include silicon nitride (Si₃N₄), aluminum nitride (AIN), silicon carbide, and aluminum oxide. Examples of sintering aids include metal oxides, fluorides, chlorides, nitrates, and sulfates of rare earth elements; and metal oxides, fluorides, chlorides, nitrates, and sulfates of alkaline earth metals. These may be used alone or in combination of two or more. The sintering aid may include oxides of alkaline earth metals, such as magnesium oxide. By using a sintering aid, sintering of the inorganic compound can be promoted.

Examples of binder resins include methyl cellulose, ethyl cellulose, polyvinyl alcohol, polyvinyl butyral, and (meth)acrylic resins. By using a binder resin, the slurry can be easily formed into various shapes such as a sheet. Examples of solvents include organic solvents such as ethanol and toluene. The viscosity of the slurry can be easily adjusted by using the binder resin and solvent.

The slurry may contain other components in addition to the inorganic compound powder, sintering aid, binder resin, and solvent. Examples of other components include plasticizers and dispersants. Examples of plasticizers include purified glycerin, glycerin trioleate, diethylene glycol, phthalic acid plasticizers such as di-n-butyl phthalate, and dibasic acid plasticizers such as di-2-ethylhexyl sebacate. Examples of dispersants include poly(meth)acrylates and (meth)acrylic acid-maleate copolymers.

The ceramic plate preparation step is a step of heat-treating the green sheet obtained by forming to obtain a ceramic plate. The heat treatment of the green sheet is performed by a plural times of heat treatments, and may include, for example, a degreasing step in which heat treatment is performed at a heating temperature of 800°C or lower, and a sintering step in which heat treatment is performed at a higher temperature than the heating temperature in the degreasing step. In the degreasing step, the green sheet is degreased mainly by burning the binder resin or the like. Then, in the sintering step, the raw material containing the inorganic compound and the sintering aid is sintered to obtain a ceramic plate.

The heating temperature in the degreasing step may be, for example, 750 to 800°C, 760 to 790°C, or 780 to 790°C. By setting the upper limit value of the heating temperature within the above range, the organic matter such as the binder resin is sufficiently removed before sintering of the inorganic compound to form a more homogeneous system, and then sintering in the subsequent second heat treatment can be performed. The heating time in the degreasing step may be, for example, 0.5 to 20 hours.

The heating temperature in the sintering step is higher than the heating temperature in the degreasing step. The heating temperature in the sintering step may be, for example, 1,600 to 1,950°C, 1,700 to 1,950°C, or 1,800 to 1,900°C. The heating time in the sintering step may be, for example, 5 to 15 hours. The sintering step may be performed under a non-oxidizing gas atmosphere such as nitrogen, argon, ammonia, and hydrogen.

The method for manufacturing a composite substrate according to the present embodiment has been described as a method including the step of preparing a ceramic plate, but instead of the green sheet preparation step and the ceramic plate preparation step, a ceramic plate prepared in advance (for example, a commercially available ceramic plate) may be used.

In the lamination step, the ceramic plate and the metal base material are laminated using a brazing material containing active metal to obtain a laminate. For example, a brazing material is applied to the front surface of a ceramic plate to form a coating film, and a metal base material is attached onto the coating film. When attaching the metal base material to both surfaces of the ceramic plate, the metal base material is pasted to both the front and back surfaces of the ceramic plate by the same operation. The shape of the metal base material may be, for example, a flat plate shape. A circuit may be formed in advance on the metal base material.

The coating film containing the brazing material can be applied to the front surface of the ceramic plate by, for example, a roll coater method, a screen printing method, a transfer method, or the like. The brazing material contains silver (Ag) as a main component and active metals as subcomponents. Examples of the active metal include titanium (Ti), zirconium (Zr), hafnium (Hf), vanadium (V), niobium (Nb), and tantalum (Ta). The brazing material may contain metals such as copper (Cu), tin (Sn), and indium (In) for the purpose of lowering the melting point. The content of the active metal in the brazing material layer may be adjusted based on the silver content being 100 parts by mass.

When the brazing materials contain copper, it is possible to reduce the influence of the heat treatment on the constituent members in the vicinity of the joining surface, and accordingly, the reliability of the obtained composite substrate can be further improved. The content of copper in the brazing materials may be, for example, 17 parts by mass or less, 15 parts by mass or less, 14 parts by mass or less, 13 parts by mass or less, or 12 parts by mass or less with respect to 100 parts by mass of the content of silver. The content of copper in the brazing materials may be, for example, 2 parts by mass or more, 4 parts by mass or more, 6 parts by mass or more, 8 parts by mass or more, or 10 parts by mass or more with respect to 100 parts by mass of the content of silver. The content of copper in the brazing materials may be adjusted within the range described above, and may be, for example, 2 to 16 parts by mass with respect to 100 parts by mass of the content of silver.

As the brazing material contains tin, it is possible to lower the melting point of the brazing material and reduce the influence of the heat treatment on the constituent members in the vicinity of the joining surface, and accordingly, the reliability of the obtained composite substrate can be further improved. The content of tin in the brazing materials is, for example, 6.0 parts by mass or less, 5.5 parts by mass or less, 5.0 parts by mass or less, 3.0 parts by mass or less, or 1.0 part by mass or less with respect to 100 parts by mass of the content of silver. The content of tin in the brazing materials may be, for example, 0.5 parts by mass or more with respect to 100 parts by mass of the content of silver. The content of tin in the brazing materials may be adjusted within the range described above, and may be, for example, 0.5 to 6.0 parts by mass with respect to 100 parts by mass of the content of silver.

When the brazing materials contain titanium, the joining strength between the ceramic plate and the metal base material can be further improved. The upper limit value of the content of titanium in the brazing material may be, for example, 7.0 parts by mass or less, 6.0 parts by mass or less, 5.0 parts by mass or less, or 4.0 parts by mass or less with respect to 100 parts by mass of the content of silver. The lower limit value of the content of titanium in the brazing materials is, for example, 0.6 parts by mass or more, 0.8 parts by mass or more, or 1.0 part by mass or more with respect to 100 parts by mass of the content of silver. The content of titanium in the brazing materials may be adjusted within the range described above, and may be, for example, 1.0 to 5.0 parts by mass with respect to 100 parts by mass of the content of silver.

The viscosity of the brazing material at 25°C may be, for example, 5 to 40 Pa·s. When the viscosity of the brazing material is within the above range, it is possible to form a more uniform coating film on the ceramic plate, the melt viscosity during heat treatment for joining becomes appropriate, and the brazing material can be spread sufficiently between the ceramic plate and the metal base material. Thus, the joining strength can be further improved, and the reliability of the composite substrate can be enhanced.

In addition to metals such as silver and active metals, the brazing material may contain, for example, an organic solvent, a binder, and the like. The content of organic solvent in the brazing material may be, for example, 5 to 25% by mass. The content of binder in the brazing material may be, for example, 2 to 15% by mass.

In the heat treatment step, the laminate is heated in a heating furnace, and the ceramic plate is made sufficiently join to the metal base material to obtain a composite substrate. In order to make the ceramic plate join to the metal base material with a sufficient joining strength and also to have excellent heat cycle characteristics, the heat treatment is performed by dividing the temperature pattern into a plurality of times. The heat treatment step may include, for example, a first heat treatment step of heat-treating the laminate at a temperature of lower than 600°C, and a second heat treatment step of heat-treating the laminate at a temperature higher than the heating temperature in the first heat treatment step.

The upper limit value of the heating temperature in the first heat treatment step may be, for example, lower than 600°C, 590°C or lower, 585°C or lower, 500°C or lower, 450°C or lower, or 410°C or lower. By setting the upper limit value of the heating temperature within the above range, joining properties can be further improved. By setting the upper limit value of the heating temperature within the above range, when the brazing material contains a binder component, the binder component is decomposed before the brazing material is melted, and the decrease in joining properties can be sufficiently suppressed. The lower limit value of the heating temperature in the first heat treatment step may be, for example, 350°C or higher, 360°C or higher, 380°C or higher, or 400°C or higher. By setting the lower limit value of the heating temperature within the above range, when the brazing material contains a binder component, insufficient decomposition of the binder component contained in the brazing material can be suppressed, and joining properties can be further improved. The heating temperature in the first heat treatment step may be adjusted within the above range, and may be, for example, 350°C or higher and lower than 600°C, or 400 to 410°C.

The upper limit value of the heating temperature in the second heat treatment step may be, for example, lower than 850°C, 845°C or lower, or 840°C or lower. By setting the upper limit value of the heating temperature within the above range, it is possible to suppress the diffusion of the components in the brazing material into the metal base material. The lower limit value of the heating temperature in the first heat treatment step may be, for example, 770°C or higher, 780°C or higher, 790°C or higher, or 800°C or higher. By setting the lower limit value of the heating temperature within the above range, it is possible to suppress defective joining due to unmelted brazing material. The heating temperature in the second heat treatment step may be adjusted within the above range, and may be, for example, 770°C or higher and lower than 850°C, or 800 to 840°C.

The heating time in the second heat treatment step is relatively short. By shortening the heating time, it is possible to suppress excessive diffusion of the components in the brazing material among the ceramic plate, the brazing material, and the metal base material which are in a heated state, and make the active metal sufficiently contribute to joining between the ceramic plate and the metal base material. The heating time in the second heat treatment step may be, for example, 90 minutes or less, 80 minutes or less, or 70 minutes or less. The heating time in the second heat treatment step may be, for example, 5 minutes or more, 10 minutes or more, or 15 minutes or more. The heating time in the second heat treatment step may be adjusted within the above range, and may be, for example, 5 to 90 minutes. The heating time in this specification means the time for maintaining the temperature after the temperature in the heating furnace reaches a predetermined temperature.

In the first heat treatment step and the second heat treatment step, the atmosphere in the furnace may be an inert gas such as nitrogen. Further, the pressure inside the furnace may be, for example, a reduced pressure lower than the atmospheric pressure, or may be a vacuum.

The first heat treatment step and the second heat treatment step may be performed while pressing the laminate in the lamination direction. The heating furnace may be of a continuous type that continuously manufactures a plurality of joints, or may be of a batch type that manufactures one or a plurality of joints.

A circuit may be formed by removing part of the metal base material in the composite substrate. This step may be performed, for example, by etching or the like. Specifically, first, a photosensitive resist is printed on the front surface of the composite substrate. Then, using an exposure device, a resist pattern having a predetermined shape is formed. The resist may be a negative type or a positive type. Uncured resist is removed, for example, by cleaning.

After forming the resist pattern, etching is performed to remove the part of the metal base material that is not covered with the resist pattern. When the metal base material has the same shape and size as the ceramic plate, the above operation can expose part of the front surface and/or the back surface of the ceramic plate at the part. After that, by removing the resist pattern, a composite substrate having a circuit can be obtained.

Although several embodiments have been described above, the mutual descriptions can be applied to common configurations. Moreover, the present disclosure is not limited to the above embodiments.

### [Examples]

The contents of the present disclosure will be described in more detail with reference to examples and comparative examples, but the present disclosure is not limited to the following examples.

Table 1 shows the compositions of the brazing materials a to c used in the following examples and comparative examples. In addition, the numbers in Table 1 indicate parts by mass of each component.

**[Table 1]**

| | Active metal type [parts by mass] | | | |
|---|---|---|---|---|
| | Ag | Cu | Sn | Ti |
| Brazing material a | 90 | 10 | 5 | 3 |
| Brazing material b | 90 | 10 | 5 | 2 |
| Brazing material c | 90 | 10 | 5 | 5 |

### (Example 1)

### [Production of composite substrate]

A ceramic plate made of silicon nitride with a thickness of 0.32 mm, a first copper plate with a thickness of 0.3 mm, and a second copper plate with a thickness of 0.25 mm were prepared. The brazing material a was applied to predetermined locations on both sides of the ceramic plate.

The first copper plate, the ceramic plate, and the second copper plate were attached in this order via the brazing material a, and heat-treated in a heating furnace at 400°C for 120 minutes in a vacuum (first heat treatment step), and then the temperature was raised to 800°C, and heat treatment was performed at that temperature for 60 minutes (second heat treatment step). In this manner, the first and second copper plates were joined to the ceramic plate.

After forming a resist pattern having a predetermined shape on the first copper plate using an exposure device, etching was performed using an aqueous solution of copper chloride and then a mixture of hydrogen peroxide and ammonium fluoride to remove the part that is not covered with the resist pattern. After that, the resist pattern was removed with an alkali peeling solution.

After removing the resist pattern, electroless plating was performed using a Ni-P plating solution (phosphorus concentration: 8 to 12% by mass) to form a circuit board having a plating film on the ceramic plate. In this manner, a composite substrate was produced.

### (Example 2)

A composite substrate was produced in the same manner as in Example 1, except that the heating temperature in the second heat treatment step was changed to 840°C.

### (Example 3)

A composite substrate was produced in the same manner as in Example 1, except that the brazing material b was used as the brazing material and the heating temperature in the second heat treatment step was changed to 800°C.

### (Example 4)

A composite substrate was produced in the same manner as in Example 1, except that the brazing material c was used as the brazing material and the heating temperature in the second heat treatment step was changed to 800°C.

### (Example 5)

A composite substrate was produced in the same manner as in Example 1, except that the heating temperature in the second heat treatment step was changed to 800°C and the heating time was changed to 5 minutes.

### (Example 6)

A composite substrate was produced in the same manner as in Example 1, except that the heating temperature in the second heat treatment step was changed to 800°C and the heating time was changed to 90 minutes.

### (Comparative Example 1)

A composite substrate was produced in the same manner as in Example 1, except that the heating temperature in the second heat treatment step was changed to 860°C.

### (Comparative Example 2)

A composite substrate was produced in the same manner as in Example 1, except that the heating temperature in the second heat treatment step was changed to 750°C.

### (Comparative Example 3)

A composite substrate was produced in the same manner as in Example 1, except that the heating temperature in the second heat treatment step was changed to 800°C and the heating time was changed to 180 minutes.

### <Evaluation of composite substrate>

For each of the composite substrates produced in Examples 1 to 6 and Comparative Examples 1 to 3, the Vickers hardness at a predetermined position was measured to determine the Vickers hardness X and Y, and the value of Y/X. Specifically, after cutting the composite substrate, the composite substrate was embedded in a resin, and the cross section was polished to produce a measurement sample. A diamond indenter was pressed into the front surface of the metal plate in this measurement sample, and after the test force was released, the diagonal length of the depression remaining on the front surface was measured, and the Vickers hardness of the measurement target was calculated. The results are shown in Tables 2 and 3.

### <Evaluation of joining strength of composite substrate: peeling strength>

For the composite substrates obtained in Examples and Comparative Examples, the peeling strength was measured to evaluate the joining strength. Specifically, the end of a 5 mm wide pattern, which was part of the copper circuit pattern joined to the composite substrate, was peeled off with pliers. The composite substrate was fixed to the table of a tensile tester, and the end of the pattern was attached to the chuck of the pull tester. At this time, the front surface of the ceramic plate was set such that the angle between the peeled copper circuit pattern and the front surface of the ceramic plate was 90° (perpendicular direction). Thereafter, the tensile tester was operated to pull upward and move the pattern peeled off via the chuck, and the maximum peeling load at that time was measured. The peeling strength was calculated by dividing the maximum peeling load by the width (0.5 cm). After the test, the peeled surface was visually observed, and the joining strength was evaluated according to the following criteria. The results are shown in Tables 2 and 3.
A: The peeling strength is 100 N/cm or more.
B: The peeling strength is 80 N/cm or more and less than 100 N/cm.
C: The peeling strength is 40 N/cm or more and less than 80 N/cm.
D: The peeling strength is less than 40 N/cm.

### <Evaluation of heat cycle characteristics of composite substrate>

For the composite substrates obtained in Examples and Comparative Examples, the heat cycle characteristics were evaluated according to the method described in JIS C 60068-2-14:2011 "Environmental testing -Part 2-14: Tests-Test N: Change of temperature ". Specifically, the heat cycle test was performed 2000 times, with one cycle consisting of maintaining at -40°C for 15 minutes and then maintaining at 150°C for 15 minutes. After the test, the copper plate and the brazing material layer were peeled off using copper chloride solution and ammonium fluoride/hydrogen peroxide etching, and cracks on the front surface of the ceramic plate were binarized (threshold value 140) using image analysis software GIMP2, and after calculating the crack area, the crack rate was determined by calculating the value of the crack areal circuit pattern area. The results are shown in Tables 2 and 3.
A: The crack rate is less than 1%.
B: The crack rate is 1% or more and less than 5%.
C: The crack rate is 5% or more.

**[Table 2]**

| | | Example 1 | Example 2 | Example 3 | Example 4 | Example 5 | Example 6 |
|---|---|---|---|---|---|---|---|
| Manufacturing conditions | Heating temperature in second heat treatment step [°C] | 780 | 840 | 800 | 800 | 800 | 800 |
| | Heating time in second heat treatment step [minutes] | 60 | 60 | 60 | 60 | 5 | 90 |
| Brazing material layer | Content of Sn [parts by mass] | 5 | 5 | 5 | 5 | 5 | 5 |
| | Content of Ti [parts by mass] | 3 | 3 | 2 | 5 | 3 | 3 |
| Composite substrate | Vickers hardness X [HV] at position of 20 µm or ceramic plate | 73 | 101 | 96 | 84 | 83 | 92 |
| | Vickers hardness Y [HV] | 60 | 69 | 52 | 76 | 50 | 77 |
| | at position of 70 µm or ceramic plate | | | | | | |
| | Value of Y/X | 0.82 | 0.68 | 0.54 | 0.90 | 0.60 | 0.84 |
| Evaluation | Joining strength (peeling strength) | A | A | A | A | A | A |
| | Heat cycle characteristics | A | A | A | A | A | A |

**[Table 3]**

| | | Comparative Example 1 | Comparative Example 2 | Comparative Example 3 |
|---|---|---|---|---|
| Manufacturing conditions | Heating temperature in second heat treatment step [°C] | 860 | 750 | 800 |
| | Heating time in second heat treatment step [minutes] | 60 | 60 | 180 |
| Brazing material layer | Content of Sn [parts by mass] | 5 | 5 | 5 |
| | Content of Ti [parts by mass] | 3 | 3 | 3 |
| Composite substrate | Vickers hardness X [HV] at position of 20 µm on ceramic plate | 118 | 70 | 123 |
| | Vickers hardness Y [HV] at position of 70 µm on ceramic plate | 73 | 67 | 77 |
| | Value of Y/X | 0.62 | 0.95 | 0.63 |
| Evaluation | Joining strength (peeling strength) | A | D | A |
| | Heat cycle characteristics | B | A | B |

### Industrial Applicability

According to the present disclosure, a composite substrate having excellent heat cycle characteristics and joining strength between a ceramic substrate and a metal base material can be provided.

### Reference Signs List

10 Ceramic plate
10A Front surface
10B Back surface
20, 22 Brazing material layer
30, 32 Metal base material
40 Circuit board
40a, 50a Joining surface
50 Heat sink
100 Composite substrate

## Claims

1. A composite substrate comprising:
a ceramic plate and a metal base material joined onto the ceramic plate via a brazing material layer containing silver and an active metal,
wherein X is 70 to 110 HV and a ratio of Y to X is 0.92 or less, where a Vickers hardness at a position of 20 µm from the ceramic plate toward the metal base material is X and a Vickers hardness at a position of 70 µm from the ceramic plate toward the metal base material is Y

2. The composite substrate according to claim 1,
wherein the ratio of Y to X is 0.50 or more.

3. The composite substrate according to claim 1 or 2,
wherein the active metal contains at least one selected from a group consisting of titanium, zirconium, hafnium, vanadium, niobium, and tantalum.

4. The composite substrate according to any one of claims 1 to 3,
wherein the ceramic plate contains silicon nitride.

5. The composite substrate according to any one of claims 1 to 4,
wherein a thickness of the brazing material layer is 20 µm or less.
